# EUROPÄISCHE PATENTSCHRIFT

(11) **EP 2 165 363 B1**
(45) Veröffentlichungstag und Bekanntmachung des Hinweises auf die Patenterteilung: **29.07.2020**
(21) Anmeldenummer: 08773469.5
(22) Anmeldetag: 16.06.2008
(51) Int. Cl.: H01L 23/482

(54) **ELEKTRISCHE SCHALTUNG MIT VERTIKALER KONTAKTIERUNG**
ELECTRIC CIRCUIT WITH VERTICAL CONTACTS
CIRCUIT ÉLECTRIQUE À MISE EN CONTACT VERTICALE

(30) Priorität: 18.06.2007 DE 102007028458
(43) Veröffentlichungstag der Anmeldung: 24.03.2010
(73) Patentinhaber: AZURSPACE Solar Power GmbH, 74072 Heilbronn (DE); Institut für Mikroelektronik Stuttgart, 70569 Stuttgart (DE)
(72) Erfinder: DAUMILLER, Ingo, 89165 Dietenheim/Regglisweiler (DE); SÖNMEZ, Ertugrul, 89075 Ulm (DE); KUNZE, Mike, 89284 Pfaffenhoffen (DE)
(74) Vertreter: Witte, Weller & Partner Patentanwälte mbB
(86) Internationale Anmeldenummer: PCT/EP2008/004838
(87) Internationale Veröffentlichungsnummer: WO 2008/155085

(56) Entgegenhaltungen:
- EP-A- 0 714 128
- US-A- 5 444 275
- US-A- 5 633 525
- US-A1- 2003 025 579
- US-A1- 2005 017 299

## Beschreibung

Die Erfindung betrifft eine elektrische Schaltung mit zumindest zwei Einheitszellen, welche in einer Ebene, in welcher nicht die Einheitszellen angeordnet sind, gemeinsam kontaktierbar sind. Die Erfindung betrifft außerdem ein Halbleiterbauelement mit einer derartigen elektrischen Schaltung sowie ein Verfahren zur Herstellung einer elektrischen Schaltung, in welcher zumindest zwei Einheitszellen in dieser Weise kontaktiert sind.

Elektrische Schaltungen können aus zwei oder mehr Einheitszellen aufgebaut sein. Solche Einheitszellen können beispielsweise Dioden, Transistoren oder andere elektronische Bauelemente sein. Diese Bauelemente können auf einem gemeinsamen Substrat ausgebildet sein. Für viele Anwendungen ist es vorteilhaft, wenn an einer elektrischen Schaltung mehrere oder auch alle Einheitszellen gemeinsam von außen kontaktierbar sind. So können beispielsweise mehrere Transistoren zusammengeschaltet werden und zusammen wie ein Transistor mit größerer Fläche wirken. Hierzu würden dann ein Source-Kontakt, ein Drain-Kontakt und ein Gate-Kontakt gemeinsam von außen kontaktiert. Entsprechend können mehrere Dioden parallel geschaltet werden und wirken dann wie eine Diode mit größerer Fläche. Die Kontakte können hierbei als Kontaktstellen auf dem gemeinsamen Substrat ausgebildet sein.

Nach dem Stand der Technik werden Kontakte verschiedener Einheitszellen mit gleicher Funktion über Busse miteinander verbunden und sind an diesen Bussen von außen kontaktierbar. Hierzu können die Busse einen Bondfleck aufweisen oder mit einem solchen in Verbindung stehen, an welchen ein Bonddraht angeordnet sein kann.

Nach dem Stand der Technik werden diese Busse in einer Ebene angeordnet, in welcher die Kontaktstellen der Einheitszellen angeordnet sind, und sind in dieser Ebene mit allen Kontaktstellen der gleichen Funktion verbunden. Auch Bondflecken zur Kontaktierung nach außen sind in der Ebene der Busse und der Kontaktstellen angeordnet.

Nachteilig bei einer solchen Anordnung ist jedoch, dass sowohl die Busse als auch ggf. die Bondflecken viel Platz auf dem Substrat beanspruchen, auf welchem die Einheitszellen und die elektrische Schaltung ausgebildet sind. Insbesondere in der Halbleitertechnik ist diese Substratfläche sehr teuer. Darüberhinaus steigt der Platzbedarf auf dem Substrat mit zunehmender Anzahl an Einheitszellen weiter an, da die Busse eine gewisse Mindestbreite auf dem Substrat erfordern, um ihren Innenwiderstand hinreichend gering zu halten. Die Breite der Busse steigt also mit dem zu leitenden Strom an.

Bekannte elektrische Schaltungen mit mehreren Einheitszellen, die aus Transistoren bestehen, werden in US 2003/0025579 A1, US 5444275 A, EP0714128 A und US 2005/0017299 A1 beschrieben.

Aufgabe der vorliegenden Erfindung ist es daher, eine elektrische Schaltung mit mehreren Einheitszellen anzugeben, welche preisgünstiger herzustellen ist, welche jedoch eine weitgehend beliebige Erhöhung der Anzahl der Einheitszellen ermöglicht, ohne dabei die auftretende Verlustleistung und den Platzbedarf auf einem Substrat zu sehr ansteigen zu lassen.

Diese Aufgabe wird gelöst durch die elektrische Schaltung nach Anspruch 1, das Halbleiterbauelement nach Anspruch 7 sowie das Verfahren zur Herstellung einer elektrischen Schaltung nach Anspruch 8. Vorteilhafte Weiterbildungen der elektrischen Schaltung sowie des Verfahrens zur Herstellung einer elektrischen Schaltung werden durch die jeweiligen abhängigen Ansprüche gegeben.

Erfindungsgemäß ist eine elektrische Schaltung mit zumindest zwei Einheitszellen, welche drei Kontaktstellen mit jeweils einer bestimmten Funktion aufweisen. Die Einheitszelle ist ein Transistor.

Die Einheitszellen weisen jeweils eine Source-Kontakstelle, eine Drain-Kontaktstelle und einer Gate-Kontaktstelle als Kontaktstellen verschiedener Funktion auf.

Die Kontaktstellen können auch als Elektroden bezeichnet werden bzw. Elektroden sein. Sie können zum Substrat nicht-sperrend bzw. als Ohm-Kontakt oder sperrend bzw. als Schottky-Kontakt ausgebildet sein.

Als Halbleitermaterialien für die Einheitszellen kommen u.a. bevorzugt solche in Frage, die zumindest ein Nitrid eines Hauptgruppe-III-Elementes enthalten oder daraus bestehen. Diese Materialien können also u.a. GaN, AlN, InN, GaAlN, GaInN, AlInN und/oder AlInGaN sein. Diese Materialien haben u.a. den Vorteil, dass mit ihnen Schaltungen realisiert werden können, die besonders resistent gegen hohe Temperaturen, insbesondere gegen Temperaturen ≥ 100 °C, besonders bevorzugt ≥ 300 °C, besonders bevorzugt ≥ 500 °C, besonders bevorzugt ≥ 700 °C sind.

Vorzugsweise weisen ein oder mehrere der Kontaktflächen jeweils zumindest einen Bondfleck auf, an welchem besonders bevorzugt zumindest ein Bonddraht angeordnet ist.

Die dielektrischen und/oder leitfähigen Schichten und/oder Kontaktflachen sind vorzugsweise flächig so ausgestaltet, dass sie in Beschichtungsverfahren herstellbar sind. Sie können also vorzugsweise Beschichtungen der jeweils darunterliegenden Fläche oder Schicht sein.

Erfindungsgemäß ist auch ein Halbleiterbauelement mit einer elektrischen Schaltung gemäß Anspruch 7.

Erfindungsgemäß ist darüber hinaus außerdem ein Verfahren zur Herstellung einer elektrischen Schaltung gemäß Anspruch 8.

Die leitfähigen Schichten können Metallschichten sein.

In einer besonders günstigen Ausführungsform kann die elektrische Schaltung Kontakte verschiedener Funktionen aufweisen, die nebeneinander so angeordnet sind, dass neben einem Kontakt einer Funktion immer oder mehrmals ein Kontakt einer anderen Funktion liegt.

Vorzugsweise werden die dielektrischen Schichten, die leitfähigen Schichten und/oder die Kontaktflächen in Beschichtungsverfahren hergestellt, wie es in der Halbleitertechnik üblich ist.

Zumindest eine der dielektrischen Schichten und/oder zumindest eine der leitfähigen Schichten und/oder zumindest eine der Kontaktstellen und/oder zumindest eine der Kontaktflächen kann vorteilhaft mittels lithographischer Methoden hergestellt werden und/oder zumindest eine der Öffnungen in zumindest einer der dielektrischen Schichten kann vorteilhaft geätzt werden.

Im Folgenden soll die Erfindung anhand einiger Figuren erläutert werden. Die Figuren beschreiben gerade linienförmige und/oder rechteckige Kontaktstellen und Kontaktflächen und ermöglichen zu verstehen, wie die Kontaktstellen, die zumindest teilweise als zumindest Abschnitte von Kreisringen und die Kontaktflächen als Sektoren einer Kreisfläche ausgebildet sind.

Es zeigt
- Figur 1: einen Ausschnitt aus einem Halbleiterbauelement mit einer Vielzahl von Transistoren als Einheitszellen,
- Figur 2: eine elektrische Schaltung mit dem Halbleiterbauelement nach Figur 1, auf welchem eine dielektrische Schicht mit Öffnungen angeordnet ist,
- Figur 3: einen Aufbau entsprechend Figur 2 mit einer auf der dielektrischen Schicht angeordneten leitfähigen Schicht,
- Figur 4: einen Aufbau entsprechend der Figur 3 mit einer zuoberst aufgebrachten zweiten dielektrischen Schicht mit einer Vielzahl von Öffnungen,
- Figur 5: einen Aufbau entsprechend Figur 4 mit einer zuoberst aufgebrachten zweiten leitfähigen Schicht,
- Figur 6: einen Aufbau entsprechend Figur 5 mit einer darauf angeordneten dritten dielektrischen Schicht mit einer Vielzahl von Öffnungen,
- Figur 7: einen Aufbau entsprechend Figur 6 mit zwei Kontaktflächen,
- Figur 8: eine Gesamtanordnung, die wie in den Ausschnitten in Fig. 1 bis 7 gezeigt aufgebaut ist, und
- Figur 9: einen Querschnitt durch den in Figur 8 gezeigten Aufbau.

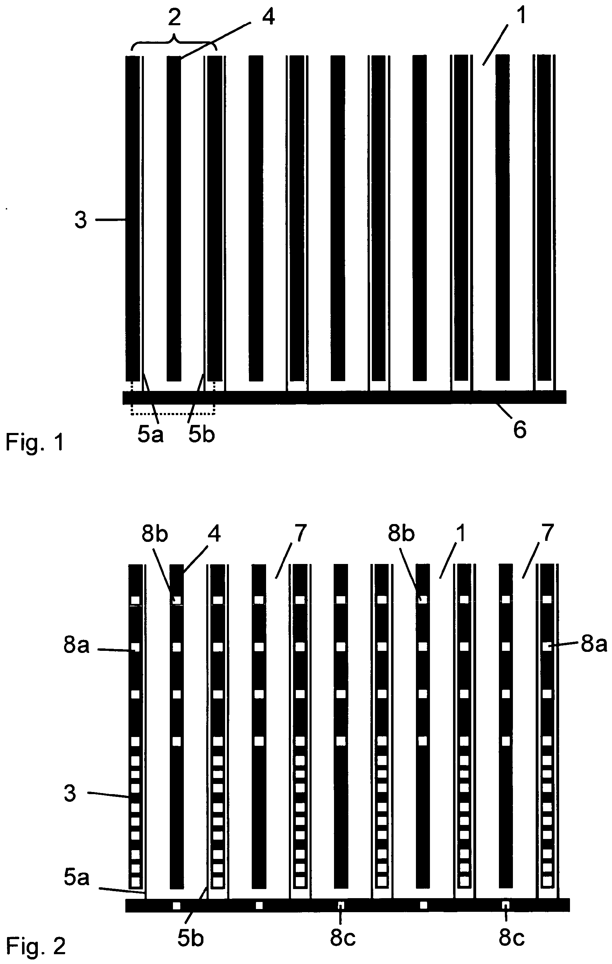

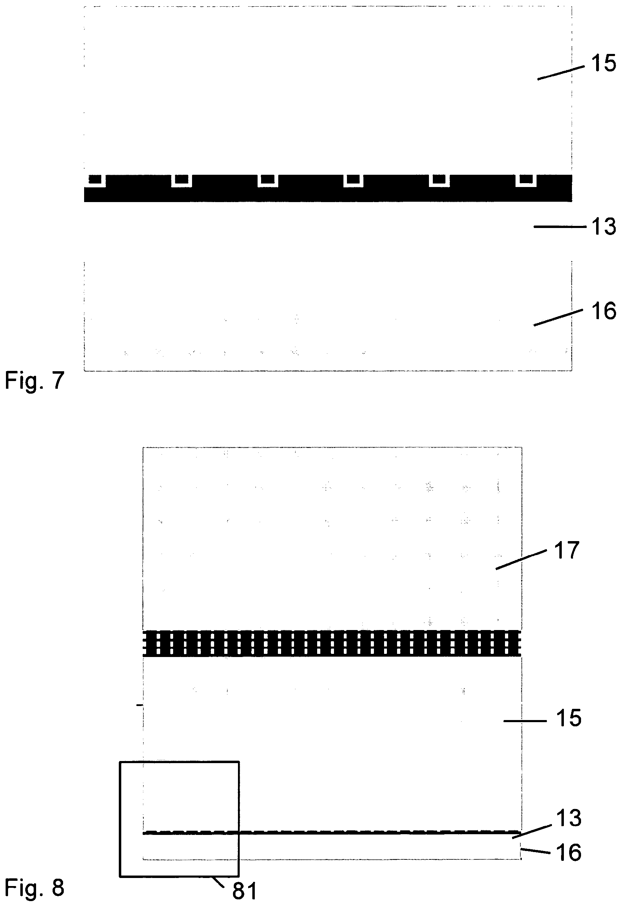

Figur 1 zeigt ein Substrat 1 mit einer Vielzahl von darauf angeordneten Einheitszellen 2, welche hier Transistoren sind. Figur 1 entspricht dem in Figur 8 gezeigten Ausschnitt 81 aus einer Ecke eines quadratischen Bauelementes. Diese Transistoren weisen jeweils einen Source-Kontakt 3, einen Drain-Kontakt 4 sowie zwei Gate-Kontakte 5a, 5b auf. Die Gate-Kontakte 5a, 5b sind über einen gemeinsamen Kontakt 6 bzw. Bus 6 verbunden.

Der Gate-Kontakt 6 (Bus) wird aus Gründen der Ebenheit analog zu den anderen Kontakten durch eine eigene Kontaktfläche kontaktiert. Hierdurch kann auch die Kontaktfläche des Gates vergrößert werden, ohne das Substrat vergrößern zu müssen.

Zwei benachbarte Transistoren teilen sich jeweils einen Source-Kontakt 3. Die Source- 3, Drain- 4 und Gate- 5a, 5b Kontakte sind hier länglich und zueinander parallel angeordnet. Source-Kontakte 3 und Drain-Kontakte 4 haben jeweils den gleichen Abstand zueinander. Die Gate-Kontakte 5a, 5b sind dicht an den Source-Kontakten angeordnet. Die Kontaktstellen 2, 3 und 4 sind hier in einer gemeinsamen Ebene angeordnet.

Figur 2 zeigt die in Figur 1 gezeigte Anordnung mit einer darauf angeordneten ersten dielektrischen Schicht 7. Diese dielektrische Schicht 7 weist Öffnungen 8a, 8b, 8c über den Kontaktstellen 3, 4, 5a, 5b auf. Durch diese Öffnungen 8a, 8b, 8c sind die Kontaktstellen 3, 4, 5a, 5b elektrisch kontaktierbar beispielsweise durch eine erste Via-Kontaktierung oder Durchkontaktierung. Die dielektrische Schicht 7 ist im gezeigten Beispiel unmittelbar auf dem Substrat und den Kontaktstellen 3, 4, 5a, 5b angeordnet und zur Fläche des Substrats 1 parallel.

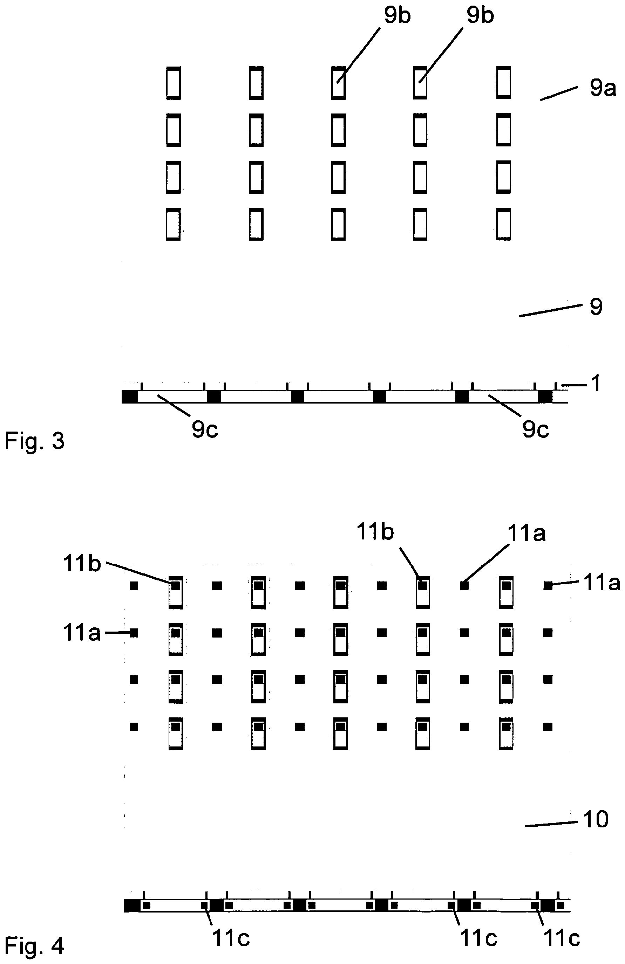

Figur 3 zeigt nun einen Aufbau entsprechend Figur 2, wobei auf jener dem Substrat 1 abgewandten Oberfläche des Aufbaus eine erste leitfähige Schicht 9 oder erste Metallisierung 9 angeordnet ist. Diese leitfähige Schicht 9 weist Bereiche für verschiedene Funktionen auf. Der Bereich 9a steht hierbei durch die Öffnungen 8a mit der Source-Kontaktstelle 3 in elektrisch leitender Verbindung. Die Bereiche 9b (eine Vielzahl von Teilbereichen 9b mit gleicher Funktion) stehen mit den Drain-Kontaktstellen 8b in elektrisch leitender Verbindung und sind von dem Bereich 9a elektrisch getrennt. Die Bereiche 9c stehen schließlich mit der Gate-Kontaktstelle 8c in elektrisch leitender Verbindung. Auch die Bereiche 9c sind vom Bereich 9 und von den Bereichen 9b elektrisch getrennt.

Figur 4 zeigt nun einen Aufbau entsprechend Figur 3, wobei auf der ersten leitfähigen Schicht 9 eine zweite dielektrische Schicht 10 angeordnet ist. Diese dielektrische Schicht 10 weist wiederum eine Vielzahl von Öffnungen 11a, 11b, 11c auf, durch welche der darunterliegende Bereich 9a, 9b oder 9c der ersten leitfähigen Metallschicht 9 kontaktierbar ist.

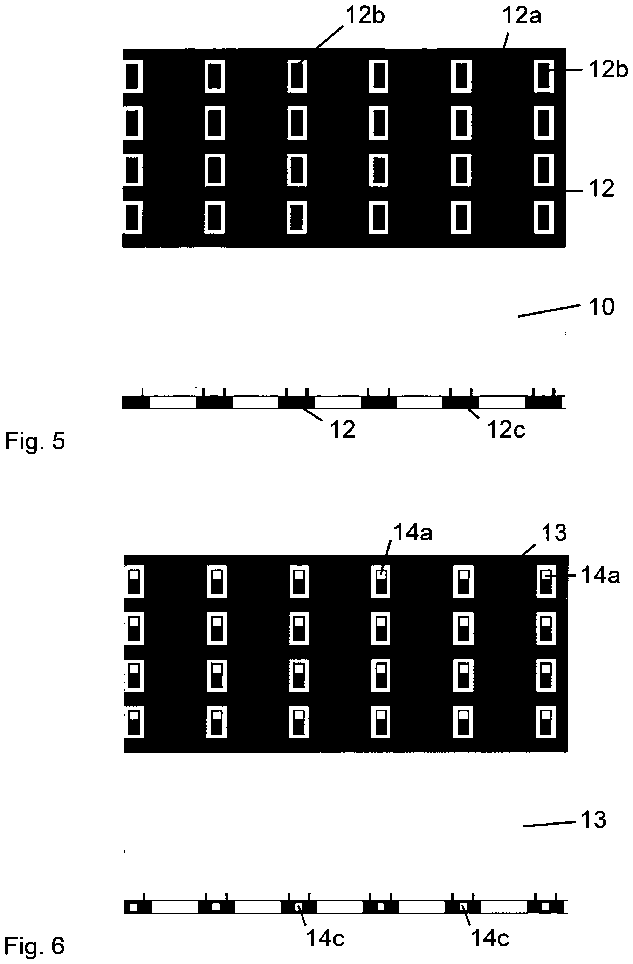

Figur 5 zeigt einen Aufbau entsprechend Figur 4, wobei auf einen Teil der zweiten dielektrischen Schicht 10 eine zweite leitfähige Schicht 12 mit zwei Bereichen 12a, 12b aufgebracht ist. Die Bereiche 12a der leitfähigen Schicht 12 kontaktieren hierbei durch die Öffnungen 11b die Bereiche 9b der ersten elektrischen Schicht 9. Diese Bereiche sind daher den Drain-Kontakten 8b zugeordnet bzw. elektrisch mit diesen verbunden. Die Bereiche 12b der zweiten elektrisch leitfähigen Schicht 12 kontaktieren über die Öffnungen 11a die Bereiche 9a der ersten leitfähigen Schicht 9 und sind daher mit den Source-Kontakten 8a in elektrischem Kontakt.

Die Bereiche 12b sind eine Vielzahl elektrisch voneinander getrennter Teilbereiche 12b, die Kontakte der gleichen Funktion kontaktieren. Sie sind über die leitfähige Schicht 9 elektrisch miteinander verbunden.

Die in Figur 3 gezeigten leitfähigen Bereiche 9c werden durch die Bereiche 12c der leitfähigen Schicht 12 über die Öffnungen 11c kontaktiert. Auch die Bereiche 12c sind hierbei elektrisch voneinander geteilte Teilbereiche mit gleicher Funktion, hier der Gate-Funktion.

Figur 6 zeigt einen Aufbau entsprechend Figur 5, wobei nun auf diesem Aufbau eine weitere dielektrische Schicht 13 aufgebracht ist. Diese dielektrische Schicht 13 weist wiederum eine Vielzahl von Öffnungen 14a, 14c auf, durch welche die darunterliegenden leitfähigen Bereiche 12b, 12c elektrisch kontaktierbar sind, beispielsweise durch eine Durchkontaktierung oder Via-Kontaktierung.

Auf den in Figur 6 gezeigten Aufbau werden nun, wie in Figur 7 gezeigt, Kontaktflächen 15 und 16 aufgebracht, welche über die Öffnungen 14a, 14c in der dielektrischen Schicht 13 die Bereiche 12b, 12c der leitfähigen Schicht 12 kontaktieren. Da die Öffnungen 14c nur über Gate-Kontakten angeordnet sind und die Kontaktfläche 16 sich nur über die Öffnungen 14c erstreckt, hat die Kontaktfläche 16 die Funktion eines Gate-Kontaktes. Entsprechend erstreckt sich die Kontaktfläche 15 nur über Öffnungen 14a, so dass sie nur die Bereiche 12b der leitfähigen Schicht 12 kontaktieren. Diese Bereiche 12b haben die Funktion eines Source-Kontaktes, daher hat auch die Kontaktfläche 15 die Funktion eines Source-Kontaktes. Die Kontaktflächen 15 und 16 sind elektrisch voneinander getrennt.

Figur 8 zeigt eine Gesamtansicht des Bauelements, aus welchem die Figuren 1 bis 7 den schichtweisen Aufbau des Ausschnitts 81 wiedergaben. Hier sind die rechteckigen Kontaktflächen 15, 16 und 17 zu erkennen, wobei die Kontaktfläche 15 wiederum die Funktion eines Source-Kontaktes, die Kontaktfläche 16 die Funktion eines Gate-Kontaktes hat. Die Kontaktfläche 17 hat die Funktion eines Drain-Kontaktes, da sie, was hier nicht gezeigt ist, die Drain-Kontaktstellen 4 des auf dem Substrat ausgebildeten Halbleiterbauelements kontaktiert. Die 70 Einzelzellen des zugrunde liegenden Bauelements sind in dieser Figur von den Kontaktflächen 15, 16, 17 verdeckt. Zwischen den einzelnen Kontakten öffnet sich ein bestimmter Abstand, der zwischen Gate- und Source-Kontakt kleiner ist als zwischen Source- und Drain-Kontakt. Zu beachten ist, dass in diesem Beispiel die Kontaktflächen 15, 16 und 17 jeweils alle Kontakte 3, 4, 5a, 5b jeweils einer Funktion gemeinsam kontaktieren.

Sieht man sich in den Figuren 1 bis 7 nur die Öffnungen oder Via-Kontakte an, so sind die Öffnungen oder Via-Kontakte in der Aufsicht mit einem definierten Abstand versetzt zueinander. Dies hat den Sinn, dass die Prozesstechnologie keine großen Höhenunterschiede erfährt.

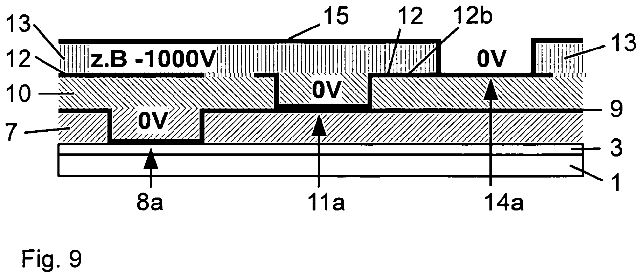

Figur 9 zeigt den Schnitt durch ein Halbleiterbauelement, wie es in den Figuren 1 bis 8 gezeigt ist, mit einer Schnittfläche senkrecht zu der Figurenebene der Figuren 1 bis 8. Zuunterst liegt das Halbleitersubstrat 1, auf welchem eine Source-Kontaktstelle 3 angeordnet ist. Hierauf ist die erste Isolationsschicht 7 angeordnet, in welcher die Öffnung 8a eingebracht ist. Auf diese Isolationsschicht 7 ist die erste leitfähige Schicht bzw. Metallisierung 9 aufgebracht, welche sich über die Isolationsschicht sowie in die Öffnung 8a hinein erstreckt, so dass sie den Source-Kontakt 3 elektrisch kontaktiert.

Auf der leitfähigen Schicht 9 ist die zweite dielektrische Schicht 10 angeordnet, die die Öffnung 11a aufweist. Auf dieser dielektrischen Schicht 10 ist nun die zweite leitfähige Schicht 12 aufgebracht, wobei sich der Bereich 12b der zweiten leitfähigen Schicht 12 in die Öffnung 11a so hineinerstreckt, dass der Bereich 12b mit der leitfähigen Schicht 9 in elektrischer Verbindung steht. Im gezeigten Fall ist die leitfähige Schicht 12 bzw. der Bereich 12b im Bereich der Öffnung 11a auf der Schicht 9 abgeschieden. Auf der zweiten leitfähigen Schicht 12 ist dann die dritte dielektrische Schicht 13 angeordnet, welche die Öffnung 14a aufweist. Auf dieser dritten dielektrischen Schicht 13 wird dann die Kontaktfläche 15 ausgebildet, welche durch die Öffnung 14a die leitfähige Schicht 12 bzw. deren Bereich 12b elektrisch kontaktiert. Auf diese Weise ist durch Abscheiden der dielektrischen Schichten 7, 10 und 13 sowie der leitfähigen Schichten 9, 12 und 15 ein großflächiger Kontakt 15 mit dem Source-Kontakt 3 hergestellt. Für den Drain- und Gate-Kontakt sehen die Schnittbilder entsprechend aus.

Die in den Figuren gezeigten elektrischen Schaltungen und deren Substrate sind hier rechteckig. Darüberhinaus sind auch die Kontaktflächen hier rechteckig. Gemäß der Erindung sind aber das Substrat und die elektrische Schaltung kreisförmig, wobei die Kontaktflächen als Kreisflächensektoren ausgebildet sind. Das Substrat 1 kann beispielsweise Nitride von Hauptgruppe III aufweisen oder daraus bestehen. Die leitfähigen Schichten können beispielsweise Metallschichten sein. Die in den Figuren gezeigten Kontaktstellen 3, 4, 5a, 5b sind hier länglich parallel zueinander ausgebildet und gerade. Gemäß der Erfindung sind jedoch die Kontaktstellen zumindest teilweise als zumindest Abschnitte von Kreisringen ausgebildet und können beispielsweise ringförmig geschlossen sind. Die isolierende Schicht kann ein klassisches Dielektrikum, wie beispielsweise SiO₂ oder SiN, wie aber auch geeignete Polymerverbindungen, wie beispielsweise BCB (Benzocyclobuten) sein. Die dielektrischen Schichten 7, 10, die leitfähigen Schichten 9, 12 und/oder die Kontaktflächen können in Beschichtungsverfahren auf die jeweils darunterliegende Schicht beschichtet werden. Die Öffnungen in den dielektrischen Schichten können geätzt oder strukturiert werden. Zur Herstellung der leitfähigen Schichten können diese Öffnungen dann großflächig strukturiert und metallisiert werden.

## Patentansprüche

1. Elektrische Schaltung mit zumindest zwei auf einem in einer Ebene ausgedehnten flächigen Substrat (1) ausgebildeten Einheitszellen, welche jeweils drei Kontaktstellen (3, 4, 5) mit verschiedener Funktion aufweisen, mit zumindest drei auf den Einheitszellen angeordneten dielektrischen Schichten, und mit zumindest drei Kontaktflächen, welche parallel zu der Ebene über den Kontaktstellen und/oder dem Substrat angeordnet sind,
wobei die Einheitszellen Transistoren mit einer Source-Kontaktstelle (3), einer Drain-Kontaktstelle (4) und einer Gate-Kontaktstelle (5a, 5b) als Kontaktstellen verschiedener Funktionen sind, wobei die Gate-Kontaktstellen (5) der Transistoren über einen gemeinsamen Bus (6) verbunden sind,
wobei Kontaktstellen mit gleicher Funktion mit zumindest einer für zumindest einen Teil der Kontaktstellen gleicher Funktion gemeinsamen Kontaktfläche über zumindest eine Durchkontaktierung durch die dielektrischen Schichten elektrisch verbunden sind,
wobei eine erste dielektrische Schicht (7) zumindest je eine Öffnung (8a, 8b, 8c) über den Source- und Drain-Kontaktstellen (3, 4) sowie dem gemeinsame Bus (6) aufweist und auf der dielektrischen Schicht (7) für jede Funktion zumindest ein Bereich einer ersten leitfähigen Schicht (9) als Bestandteil der Durchkontaktierung angeordnet ist, welche sich so in die Öffnungen (8a, 8b, 8c) erstreckt, dass sie mit den Kontaktstellen und dem Bus (3, 4, 6) der entsprechenden Funktion in elektrischem Kontakt steht,
wobei auf der ersten leitfähigen Schicht (9) eine zweite dielektrische Schicht (10) angeordnet ist, welche die drei Funktionen entsprechende Bereiche der ersten leitfähigen Schichten (9) zumindest bereichsweise überdeckt und zumindest eine Öffnung (11a, 11b, 11c) zu jedem der von ihr überdeckten Bereiche der ersten leitfähigen Schicht (9) aufweist,
wobei auf der zweiten dielektrischen Schicht (10) für jede Funktion zumindest ein Bereich einer zweiten leitfähigen Schicht (12) als Bestandteil der Durchkontaktierung angeordnet ist, welche sich so in die Öffnungen (11a, 11b, 11c) in der zweiten dielektrischen Schicht (10) erstreckt, dass sie mit zumindest einem Bereich der darunterliegenden Bereiche der ersten leitfähigen Schicht in elektrischem Kontakt steht,
wobei auf der zweiten leitfähigen Schicht (12)eine dritte dielektrische Schicht (13) angeordnet ist, welche die drei Funktionen entsprechenden Bereiche der zweiten leitfähigen Schicht (12) zumindest bereichsweise überdeckt und zumindest eine Öffnung (14a, 14b, 14c) zu jedem der von ihr überdeckten Bereiche der zweiten leitfähigen Schicht (12) aufweist,
wobei auf der dritten dielektrischen Schicht (13) für jede Funktion zumindest ein Bereich einer dritten leitfähigen Schicht angeordnet ist, welche sich so in die Öffnungen (14a, 14b, 14c) in der dritten dielektrischen Schicht (13) erstreckt, dass sie mit zumindest einem Bereich der darunterliegenden Bereiche der zweiten leitfähigen Schicht in elektrischem Kontakt steht,
wobei die Bereiche für jede Funktion der dritten elektrischen Schicht die Kontaktflächen bilden, so dass die Kontaktstellen mit gleicher Funktion über die entsprechende Kontaktfläche gemeinsam von außen kontaktierbar sind,
wobei die Bereiche der ersten, zweiten und dritten leitfähigen Schicht je in einer Ebene angeordnet sind und Bereiche unterschiedlicher Funktionen elektrisch voneinander getrennt sind,
wobei die Kontaktstellen länglich ausgebildet sind und sich die Öffnungen zumindest abschnittsweise parallel zu den Kontaktstellen länglich erstrecken, und
wobei die Einheitszellen auf einem kreisflächenförmigen Substrat angeordnet sind, die Kontaktstellen zumindest teilweise als zumindest Abschnitte von Kreisringen ausgestaltet sind und die Kontaktflächen als Sektoren einer Kreisfläche ausgestaltet sind, die mit im Wesentlichen gleichen Abmessungen wie das Substrat zu diesem parallel angeordnet ist.

2. Elektrische Schaltung nach dem vorhergehenden Anspruch, **dadurch gekennzeichnet, dass** die Transistoren Feldeffekttransistoren sind.

3. Elektrische Schaltung nach einem der vorhergehenden Ansprüche, **dadurch gekennzeichnet, dass** die Kontaktstellen zueinander parallel und/oder ringförmig geschlossen ausgebildet sind und vorzugsweise auf dem Substrat zu diesem Parallel angeordnet sind, wobei besonders bevorzugt das Substrat elektrisch leitend oder halbleitend ist.

4. Elektrische Schaltung nach einem der vorhergehenden Ansprüche, **dadurch gekennzeichnet, dass** die Sektoren als Drittel der Kreisfläche ausgestaltet sind.

5. Elektrische Schaltung nach einem der vorhergehenden Ansprüche, **dadurch gekennzeichnet, dass** unmittelbar benachbart zu zumindest einigen, vorzugsweise allen, Kontaktstellen einer Funktion zumindest eine Kontaktstelle einer anderen Funktion angeordnet ist, wobei die Kontaktstellen vorzugsweise unmittelbar aneinander angeordnet sind, besonders bevorzugt über eine Isolation.

6. Elektrische Schaltung nach einem der vorhergehenden Ansprüche, **dadurch gekennzeichnet, dass** zumindest eine der Einheitszellen einen Halbleiter aufweist, der zumindest ein Nitrid zumindest eines Hauptgruppe-III-Elementes aufweist oder daraus besteht, vorzugsweise der GaN, AlN, InN, AlGaN, InGaN, AlInN und/oder AlGaInN aufweist oder daraus besteht.

7. Halbleiterbauelement mit einer elektrischen Schaltung nach einem der vorhergehenden Ansprüche.

8. Verfahren zur Herstellung einer elektrischen Schaltung mit zumindest zwei auf einem in einer Ebene ausgedehnten Substrat (1) ausgebildeten Einheitszellen, welche jeweils drei Kontaktstellen (3, 4, 5) mit verschiedener Funktion aufweisen,
wobei auf den Kontaktstellen (3, 4, 5) drei dielektrische Schichten (7, 10, 13) mit Öffnungen (8a, 8b, 8c, 11a, 11b, 11c, 14a, 14b, 14c) so hergestellt werden, dass die Kontaktstellen (3, 4, 5) durch die Öffnungen (8a, 8b, 8c, 11a, 11b, 11c, 14a, 14b, 14c) über Kontaktflächen kontaktierbar sind,
wobei die Einheitszellen Transistoren mit einer Source-Kontaktstelle (3), einer Drain-Kontaktstelle (4) und einer Gate-Kontaktstelle (5a, 5b) als Kontaktstellen verschiedener Funktionen sind, wobei die Gate-Kontaktstellen (5) der Transistoren über einen gemeinsamen Bus (6) verbunden sind,
wobei auf einer ersten dielektrischen Schicht (7) zumindest eine erste leitfähige Schicht (9) mit für die drei Funktionen elektrisch getrennten Bereichen hergestellt wird, welche in den Bereichen die Source- und Drain-Kontaktstellen (3, 4) sowie den gemeinsamen Bus (6) mit entsprechender Funktion kontaktiert,
wobei auf der ersten leitfähigen Schicht (9) zumindest bereichsweise eine zweite dielektrische Schicht (10) mit Öffnungen (11a, 11b, 11c) so hergestellt wird, dass durch die Öffnungen (11a, 11b, 11c) die von der zweiten dielektrischen Schicht (10) überdeckten Bereiche der ersten leitfähigen Schicht (9) kontaktierbar sind,
wobei auf der zweiten dielektrischen Schicht (10) eine zweite leitfähige Schicht (12) mit für die drei Funktionen elektrisch getrennten Bereichen hergestellt wird, welche in jedem Bereich mit dem Bereich der ersten leitfähigen Schicht mit entsprechender Funktion durch zumindest einen Teil der Öffnungen (11a, 11b, 11c) in elektrischem Kontakt steht,
wobei auf der zweiten leitfähigen Schicht (12) zumindest bereichsweise eine dritte dielektrische Schicht (13) mit Öffnungen (14a, 14b, 14c) so hergestellt wird, dass durch die Öffnungen (14a, 14b, 14c) die von der dritten dielektrischen Schicht (13) überdeckten Bereiche der zweiten leitfähigen Schicht (12) kontaktierbar sind,
wobei auf der dritten dielektrischen Schicht (13) eine dritte leitfähige Schicht (15) mit für die drei Funktionen elektrisch getrennten Bereichen hergestellt wird, welche die Kontaktflächen bilden, so dass die Kontaktstellen mit gleicher Funktion über die entsprechende Kontaktfläche gemeinsam von außen kontaktierbar sind,
wobei die Bereiche der ersten, zweiten und dritten leitfähigen Schicht je in einer Ebene angeordnet sind und Bereiche unterschiedlicher Funktionen elektrisch voneinander getrennt sind,
wobei die Kontaktstellen länglich ausgebildet sind und sich die Öffnungen zumindest abschnittsweise parallel zu den Kontaktstellen länglich erstrecken, und
wobei die Einheitszellen auf einem kreisflächenförmigen Substrat angeordnet sind, die Kontaktstellen zumindest teilweise als zumindest Abschnitte von Kreisringen ausgestaltet sind und die Kontaktflächen als Sektoren einer Kreisfläche ausgestaltet sind, die mit im Wesentlichen gleichen Abmessungen wie das Substrat zu diesem parallel angeordnet ist.

9. Verfahren nach Anspruch 8, **dadurch gekennzeichnet, dass** eine elektrische Schaltung nach einem der Ansprüche 2 bis 6 hergestellt wird.

## Claims

1. An electrical circuit comprising at least two unit cells which are configured on a flat substrate (1) which extends in one layer, wherein each comprise three contact points (3, 4, 5) with different functions, comprising at least three dielectric layers which are arranged on the unit cells, and comprising at least three contact surfaces which are arranged parallel to the layer above the contact points and/or the substrate,
wherein the unit cells are transistors comprising a source contact point (3), a drain contact point (4) and a gate contact point (5a, 5b) as contact points of different functions, wherein the gate contact points (5) of the transistors are connected via a common bus (6),
wherein the contact points with the same function are electrically connected via at least one through-plating through the dielectric layers to at least one contact surface that is common for at least some of the contact points with the same function,
wherein a first dielectric layer (7) comprises at least one opening (8a, 8b, 8c) above the source and drain contact points (3, 4) and the common bus (6), and wherein on the dielectric layer (7) for each function at least one region of a first conductive layer (9) is arranged as part of the through-plating, which extends into the openings (8a, 8b, 8c) such that it is in electrical contact with the contact points and the bus (3, 4, 6) of the corresponding function,
wherein on the first conductive layer (9) a second dielectric layer (10) is arranged, which at least partially covers the regions of the first conductive layers (9) corresponding to the three functions and comprises at least one opening (11a, 11b, 11c) to each of the regions of the first conductive layer (9) covered by it,
wherein on the second dielectric layer (10) for each function at least one region of a second conductive layer (12) as part of the through-plating is arranged, which extends into the openings (11a, 11b, 11c) in the second dielectric layer (10) such that they are in electrical contact with at least one region of the underlying regions of the first conductive layer,
wherein on the second conductive layer (12) a third dielectric layer (13) is arranged, which at least partially covers the regions of the second conductive layer (12) corresponding to the three functions and comprises at least one opening (14a, 14b, 14c) to each of the regions of the second conductive layer (12) covered by it,
wherein on the third dielectric layer (13) for each function at least one region of a third conductive layer is arranged, which extends into the openings (14a, 14b, 14c) in the third dielectric layer (13) such that it is in electrical contact with at least one region of the underlying regions of the second conductive layer,
wherein the regions for each function of the third electrical layer forming the contact surfaces, such that the contact points with the same function are commonly contactable from the outside via the corresponding contact surface,
wherein the regions of the first, second and third conductive layers are each arranged in a layer and wherein the regions of different functions are electrically separated from each other,
wherein the contact points are elongated and the openings at least partially extend longitudinally parallel to the contact points, and
wherein the unit cells are arranged on a circular substrate, wherein the contact points are at least partially formed as at least portions of circular rings and wherein the contact surfaces are formed as sectors of a circular area which is arranged parallel to the substrate with substantially the same dimensions as the latter.

2. The electrical circuit according to the previous claim, **characterized in that** the transistors are field effect transistors.

3. The electrical circuit according to one of the preceding claims, **characterized in that** the contact points are formed parallel and/or circularly closed to one another and are preferably arranged on the substrate parallel thereto, wherein particularly preferably the substrate is electrically conductive or semiconductive.

4. The electrical circuit according to one of the preceding claims, **characterized in that** the sectors are formed as a third of the circular surface.

5. The electrical circuit according to one of the preceding claims, **characterized in that** at least one contact point of another function is arranged directly adjacent to at least some, preferably all, contact points of one function, wherein the contact points are preferably arranged directly adjacent to one another, particularly preferably via an isolation.

6. The electrical circuit according to one of the preceding claims, **characterized in that** at least one of the unit cells comprises a semiconductor which comprises or consist of at least one nitride of at least one main group-III-element, preferably GaN, AlN, InN, AlGaN, InGaN, AlInN and/or AlGaInN.

7. A semiconductor device comprising an electrical circuit according to one of the preceding claims.

8. A method for producing an electrical circuit comprising at least two unit cells which are configured on a substrate (1), which extends in one layer, wherein each unit cells comprises three contact points (3, 4, 5) with different functions,
wherein three dielectric layers (7, 10, 13) with openings (8a, 8b, 8c, 11a, 11b, 11c, 14a, 14b, 14c) are arranged on the contact points (3, 4, 5) such that the contact points (3, 4, 5) can be contacted through the openings (8a, 8b, 8c, 11a, 11b, 11c, 14a, 14b, 14c) via contact surfaces,
wherein the unit cells are transistors comprising a source contact point (3), a drain contact point (4) and a gate contact point (5a, 5b) as contact points of different functions, wherein the gate contact points (5) of the transistors are connected via a common bus (6),
wherein on a first dielectric layer (7) at least one first conductive layer (9) comprising electrically separated regions for the three functions is arranged, which contacts in the regions the source and drain contact points (3, 4) and the common bus (6) having a corresponding function,
wherein on the first conductive layer (9) at least partially a second dielectric layer (10) comprising openings (11a, 11b, 11c) is arranged such that the regions of the first conductive layer (9) which are covered by the second dielectric layer (10) can be contacted through the openings (11a, 11b, 11c),
wherein on the second dielectric layer (10) a second conductive layer (12) comprising electrically separated regions for the three functions is arranged which is in each region in electrical contact with the region of the first conductive layer comprising a corresponding function through at least a part of the openings (11a, 11b, 11c),
wherein on the second conductive layer (12) at least partially a third dielectric layer (13) comprising openings (14a, 14b, 14c) is arranged such that the regions of the second conductive layer (12) which are covered by the third dielectric layer (13) can be contacted through the openings (14a, 14b, 14c),
wherein on the third dielectric layer (13) a third conductive layer (15) comprising electrically separated regions for the three functions is produced which form the contact surfaces, such that the contact points with the same function are commonly contactable from the outside via the corresponding contact surface,
wherein the regions of the first, second and third conductive layers are each arranged in a layer and regions of different functions are electrically separated from each other,
wherein the contact points are elongated and the openings extending longitudinally at least partially parallel to the contact points, and
wherein the unit cells are arranged on a circular substrate, wherein the contact points are at least partially formed as at least portions of circular rings and wherein the contact surfaces are formed as sectors of a circular area which is arranged parallel to the substrate with substantially the same dimensions as the latter.

9. Method according to claim 8, **characterized in that** an electrical circuit according to one of claims 2 to 6 is produced.

## Revendications

1. Circuit électrique comprenant au moins deux cellules élémentaires formées sur un substrat (1) plat étendu dans un plan, lesquelles possèdent respectivement trois points de contact (3, 4, 5) ayant des fonctions différentes, comprenant au moins trois couches diélectriques disposées sur les cellules élémentaires, et comprenant au moins trois surfaces de contact qui sont disposées parallèlement au plan au-dessus des points de contact et/ou du substrat,
les cellules élémentaires étant des transistors comprenant un point de contact de source (3), un point de contact de drain (4) et un point de contact de gâchette (5a, 5b) en tant que points de contact ayant des fonctions différentes, les points de contact de gâchette (5) des transistors étant reliés par le biais d'un bus commun (6),
les points de contact ayant la même fonction étant reliés électriquement à au moins une surface de contact commune pour au moins une partie des points de contact ayant la même fonction par le biais d'au moins un trou d'interconnexion à travers les couches diélectriques,
une première couche diélectrique (7) possédant au moins respectivement une ouverture (8a, 8b, 8c) au-dessus des points de contact de source et de drain (3, 4) ainsi que du bus commun (6) et sur la couche diélectrique (7), pour chaque fonction, au moins une zone d'une première couche conductrice (9) en tant que partie constitutive du trou d'interconnexion étant disposée, laquelle s'étend dans les ouvertures (8a, 8b, 8c) de telle sorte qu'elle se trouve en contact électrique avec les points de contact et le bus (3, 4, 6) de la fonction correspondante,
une deuxième couche diélectrique (10) étant disposée sur la première couche conductrice (9), laquelle recouvre au moins dans certaines zones les zones de la première couche conductrice (9) correspondant aux trois fonctions et possède au moins une ouverture (11a, 11b, 11c) vers chacune des zones de la première couche conductrice (9) qu'elle recouvre,
au moins une zone d'une deuxième couche conductrice (12) en tant que partie constitutive du trou d'interconnexion étant disposée sur la deuxième couche diélectrique (10) pour chaque fonction, laquelle s'étend dans les ouvertures (11a, 11b, 11c) dans la deuxième couche diélectrique (10) de telle sorte qu'elle se trouve en contact électrique avec au moins une zone des zones de la première couche conductrice qui se trouvent au-dessous,
une troisième couche diélectrique (13) étant disposée sur la deuxième couche conductrice (12), laquelle recouvre au moins dans certaines zones les zones de la deuxième couche conductrice (12) correspondant aux trois fonctions et possède au moins une ouverture (14a, 14b, 14c) vers chacune des zones de la deuxième couche conductrice (12) qu'elle recouvre,
au moins une zone d'une troisième couche conductrice étant disposée sur la troisième couche diélectrique (13) pour chaque fonction, laquelle s'étend dans les ouvertures (14a, 14b, 14c) dans la troisième couche diélectrique (13) de telle sorte qu'elle se trouve en contact électrique avec au moins une zone des zones de la deuxième couche conductrice qui se trouvent au-dessous,
les zones pour chaque fonction de la troisième couche électrique formant les surfaces de contact, de sorte que le contact avec les points de contact ayant la même fonction peut être établi en commun depuis l'extérieur par le biais de la surface de contact correspondante,
les zones de la première, de la deuxième et de la troisième couche conductrice étant respectivement disposées dans un plan et des zones ayant des fonctions différentes étant séparées électriquement les unes des autres,
les points de contact étant de configuration allongée et les ouvertures s'étendant en longueur au moins dans certaines portions parallèlement aux points de contact, et
les cellules élémentaires étant disposées sur un substrat en forme de surface circulaire, les points de contact étant au moins partiellement configurés sous la forme au moins de portions d'anneaux circulaires et les surfaces de contact étant configurées sous la forme de secteurs d'une surface circulaire qui est disposée parallèlement au substrat avec sensiblement les mêmes dimensions que celui-ci.

2. Circuit électrique selon la revendication précédente, **caractérisé en ce que** les transistors sont des transistors à effet de champ.

3. Circuit électrique selon l'une des revendications précédentes, **caractérisé en ce que** les points de contact sont réalisés parallèles les uns aux autres et/ou en forme d'anneau fermé et sont de préférence disposés sur le substrat parallèlement à celui-ci, le substrat étant particulièrement préférablement électriquement conducteur ou semiconducteur.

4. Circuit électrique selon l'une des revendications précédentes, **caractérisé en ce que** les secteurs sont configurés en tant que tiers de la surface circulaire.

5. Circuit électrique selon l'une des revendications précédentes, **caractérisé en ce qu'**au moins un point de contact ayant une autre fonction est disposé directement adjacent à au moins certains, de préférence tous les points de contact ayant une fonction donnée, les points de contact étant de préférence disposés directement les uns contre les autres, particulièrement préférablement par le biais d'une isolation.

6. Circuit électrique selon l'une des revendications précédentes, **caractérisé en ce qu'**au moins l'une des cellules élémentaires possède un semiconducteur, qui possède au moins un nitrure d'au moins un élément du groupe principal III ou en est composé, qui possède de préférence du GaN, de l'AlN, de l'InN, de l'AlGaN, de l'InGaN, de l'AlInN et/ou de l'AlGaInN ou en est composé.

7. Composant semiconducteur comprenant un circuit électrique selon l'une des revendications précédentes.

8. Procédé de fabrication d'un circuit électrique comprenant au moins deux cellules élémentaires formées sur un substrat (1) étendu dans un plan, lesquelles possèdent respectivement trois points de contact (3, 4, 5) ayant des fonctions différentes, trois couches diélectriques (7, 10, 13) pourvues d'ouvertures (8a, 8b, 8c, 11a, 11b, 11c, 14a, 14b, 14c) étant produites sur les points de contact (3, 4, 5) de telle sorte que le contact avec les points de contact (3, 4, 5) peut être établi à travers les ouvertures (8a, 8b, 8c, 11a, 11b, 11c, 14a, 14b, 14c) par le biais de surfaces de contact,
les cellules élémentaires étant des transistors comprenant un point de contact de source (3), un point de contact de drain (4) et un point de contact de gâchette (5a, 5b) en tant que points de contact ayant des fonctions différentes, les points de contact de gâchette (5) des transistors étant reliés par le biais d'un bus commun (6),
au moins une première couche conductrice (9) comprenant des zones séparées électriquement pour les trois fonctions étant produite sur une première couche diélectrique (7), laquelle entre en contact dans les zones avec les points de contact de source et de drain (3, 4) ainsi que le bus commun (6) ayant la fonction correspondante, une deuxième couche diélectrique (10) comprenant des ouvertures (11a, 11b, 11c) étant produite au moins dans certaines zones sur la première couche conductrice (9) de telle sorte que le contact avec les zones de la première couche conductrice (9) recouvertes par la deuxième couche diélectrique (10) peut être établi à travers les ouvertures (11a, 11b, 11c),
une deuxième couche conductrice (12) comprenant des zones séparées électriquement pour les trois fonctions étant produite sur la deuxième couche diélectrique (10), laquelle se trouve en contact électrique dans chaque zone avec la zone de la première couche conductrice ayant la fonction correspondante par le biais d'au moins une partie des ouvertures (11a, 11b, 11c),
une troisième couche diélectrique (13) comprenant des ouvertures (14a, 14b, 14c) étant produite au moins dans certaines zones sur la deuxième couche conductrice (12) de telle sorte que le contact avec les zones de la deuxième couche conductrice (12) recouvertes par la troisième couche diélectrique (13) peut être établi à travers les ouvertures (14a, 14b, 14c),
une troisième couche conductrice (15) comprenant des zones séparées électriquement pour les trois fonctions étant produite sur la troisième couche diélectrique (13), lesquelles forment les surfaces de contact, de sorte que le contact avec les points de contact ayant la même fonction peut être établi en commun depuis l'extérieur par le biais de la surface de contact correspondante,
les zones de la première, de la deuxième et de la troisième couche conductrice étant respectivement disposées dans un plan et des zones ayant des fonctions différentes étant séparées électriquement les unes des autres,
les points de contact étant de configuration allongée et les ouvertures s'étendant en longueur au moins dans certaines portions parallèlement aux points de contact, et
les cellules élémentaires étant disposées sur un substrat en forme de surface circulaire, les points de contact étant au moins partiellement configurés sous la forme au moins de portions d'anneaux circulaires et les surfaces de contact étant configurées sous la forme de secteurs d'une surface circulaire qui est disposée parallèlement au substrat avec sensiblement les mêmes dimensions que celui-ci.

9. Procédé selon la revendication 8, **caractérisé en ce qu'**un circuit électrique selon l'une des revendications 2 à 6 est produit.
